# EUROPÄISCHE PATENTANMELDUNG

(11) **EP 2 701 181 A2**
(43) Veröffentlichungstag der Anmeldung: **26.02.2014**
(21) Anmeldenummer: 13005381.2
(22) Anmeldetag: 26.08.2011
(51) Int. Cl.: H01L 21/033, H01L 21/3213

(54) **Verfahren zur Herstellung von Halbleiterbauelementen auf einem Substrat sowie Substrat mit Halbleiterbauelementen**

(62) Teilanmeldung aus: 11006972.1
(71) Anmelder: Espros Photonics AG, 7320 Sargans (CH)
(72) Erfinder: De Coi, Beat, 7320 Sargans (CH); Popp, Martin, 7000 Chur (CH); Annese, Marco, 7000 Chur (CH)
(74) Vertreter: Otten, Roth, Dobler & Partner

(57) **Zusammenfassung**

Verfahren zur Herstellung von Halbleiterbauelementen auf einem Substrat mit fotolithographischen Strukturierungsschritten, bei welchem auf dem Substrat eine erste zu strukturierende Schicht und eine für die erste zu strukturierende Schicht als Maskenschicht dienende zweite Schicht aufgebracht wird, dadurch gekennzeichnet, dass eine als Maske für die zweite Schicht dienende dritte Schicht (401) aufgebracht wird und dass nacheinander zumindest zwei fotolithografische Strukturierungsprozesse für die zweite Schicht durchgeführt werden, wobei bei einem der Strukturierungsprozesse nach der Erzeugung einer Struktur aus einer fotoempfindlichen Schicht zur Bereitstellung einer Maskenschicht für einen Strukturierungsprozess an der dritten Schicht (401), an den Strukturierungsrändern der dritten Schicht positive Rampenwinkel α erzeugt werden, wodurch sich die freibleibenden Strukturen (420) bei einer Dicke h der dritten Schicht um einen Wert D=2*h/tanα verkleinern und wobei beim Anderen der Strukturierungsprozesse nach der Erzeugung einer Struktur aus einer fotoempfindlichen Schicht für die Bereitstellung einer Maskeschicht für einen Strukturierungsprozess an der dritten Schicht (401), an den Strukturierungsrändern der dritten Schicht negative Rampenwinkel β erzeugt werden, wobei sich die verbleibenden Strukturen bei einer Dicke h der dritten Schicht um einen Wert W=2*h/tanβ verkleinern und wobei auf der Basis der jeweils strukturierten dritten Schicht (401) eine Strukturierung der zweiten Schicht erfolgt.

## Beschreibung

Die Erfindung betrifft ein Verfahren zur Herstellung von Halbleiterbauelementen auf einem Substrat nach dem Oberbegriff des Anspruchs 1 sowie ein Substrat mit Halbleiterbauelementen.

### Stand der Technik:

Bei der Halbleiterherstellung ist es bekannt, auf einer Waferoberfläche durch fotolithographische Prozesse Strukturen herzustellen. Zum Beispiel werden auf eine fotosensitive Schicht Strukturen mit einem fotolithographischen Stepper oder Scanner projiziert. Neben anderen Strukturen werden z. B. Gatebereiche von Transistorgates von integrierten Schaltungen regelmäßig durch einen fotolithographischen Prozess auf der Grundlage der Strukturierung einer Polysiliziumschicht auf der Oberfläche eines Dielektrikums, z. B. Siliziumoxid oder Siliziumoxinitrid hergestellt. Die minimalen erreichbaren Größen für Linienstrukturen und genauso die minimalen erreichbaren Abstände zwischen benachbarten Linienstrukturen sind durch die Parameter eines fotolithographischen Systems limitiert. Ein limitierender Faktor ist z. B. die vorherrschende Wellenlänge für die Beleuchtung für eine Lichtquelle bei der Projektion der Strukturen auf die Oberfläche eines zu strukturierenden Substrats. Daneben sind mechanische Toleranzen und die Apertur des optischen Pfades limitierende Faktoren. Für ein bestehendes fotolithographisches System ist die minimale erreichbare Strukturgröße ein fester Parameter, der als kritische Dimension bezeichnet wird. Regelmäßig ist eine kritische Spaltdimension ungefähr in der Größenordnung einer kritischen Liniendimension. Halbleiterprozesse werden häufig genau nach diesen Parametern spezifiziert, z. B. 200-nm-Technologieknoten oder 90-nm-Technologieknoten.

Der Übergang zu einer Technologie mit einer kleineren kritischen Dimension ist sehr teuer, weshalb man versucht in der bestehenden Technologie möglichst kleine Dimensionen erreichen zu können.

Für die Eigenschaften, z. B. eines Transistors kann es vorteilhaft sein kann, eine möglichst kleine Gatekanallänge zu erreichen. Bei kleinerer Gatekanallänge kann die notwendige Versorgungsspannung reduziert werden, womit sich die Leistungsaufnahme erniedrigt. Darüber hinaus ist eine Erhöhung der Taktrate möglich.

Bei dem Versuch kleinere Strukturen zu erreichen, stellt sich jedoch der Nachteil ein, dass der Abstand zwischen den Strukturen zunimmt, d. h. die Spaltbreite zwischen den Strukturen vergrößert sich. Bei bestimmten Anwendungen ist gerade ein möglichst geringer Abstand zwischen Gatesstrukturen gewünscht, z. B. bei CCDs (Charge coupled devices). Um dies zu erreichen, wird aus dem Stand der Technik bekannt eine Technologie eingesetzt, bei der ein zweifacher Gatestrukturierungsprozess zur Anwendung kommt. Durch Überlappung von zwei Gatestrukturen lässt sich ein minimaler Abstand zwischen den Gates erzeugen.

Bei diesem Prozess leidet jedoch die Performance von Standardtransistoren aufgrund eines erforderlichen Hochtemperaturoxidationsprozesses zur Erzeugung eines Oxidabstandshalters zwischen zwei Polysiliziumschichten.

Weiterhin ist es möglich einen verbesserten fotolithographischen Prozess einzusetzen, mit welchem kleinere Strukturen realisiert werden können. Dies ist jedoch mit einem deutlichen Mehraufwand an Kosten verbunden.

### Aufgabe und Vorteile Erfindung:

Der Erfindung liegt die Aufgabe zugrunde einen fotolithographischen Prozess zur Erzeugung von Halbleiterstrukturen mit einer vorgegebenen kritischen Dimension für Spalte und Linien im Hinblick auf die Größe der kritischen Dimension zu verbessern.

Diese Aufgabe wird durch die Merkmale des Anspruchs 1 sowie 10 gelöst.

In den abhängigen Ansprüchen sind vorteilhafte und zweckmäßige Weiterbildungen der Erfindung angegeben.

Die Erfindung geht von einem Verfahren zur Herstellung von Halbleiterbauelementen auf einem Substrat mit fotolithographischen Strukturierungsschritten aus, bei welchem auf dem Substrat eine erste zu strukturierende Schicht und eine für die erste zu strukturierende Schicht als Maskenschicht dienende zweite Schicht aufgebracht wird. Die erste zu strukturierende Schicht ist z. B. eine Polysiliziumschicht die im späteren Verfahren für die Herstellung von Transistorgates genutzt werden kann. Das Substrat ist z. B. ein Siliziumwafer, der in bekannter Art vorbereitet ist, z. B. dotierte Bereiche, geätzte Strukturen und mit einem Isolator aufgefüllte Lücken bzw. Spalte enthält. Zusätzlich kann vor der Aufbringung des Polysiliziums eine weitere Isolationsschicht aufgebracht sein, die z. B. als Transistordielektrikum dient.

Die zweite Schicht kann z. B. eine Oxidschicht z. B. aus Siliziumoxid oder Siliziumoxinitrid sein.

Der Kern der Erfindung liegt nun darin, dass eine als Maske für die zweite Schicht dienende dritte Schicht aufgebracht wird und dass nacheinander zumindest zwei fotolithographische Strukturierungsprozesse für die zweite Schicht durchgeführt werden, wobei bei einem der Strukturierungsprozesse nach der Erzeugung einer Struktur aus einer fotoempfindlichen Schicht zur Bereitstellung einer Maskenschicht für einen Strukturierungsprozess an der dritten Schicht, an den Strukturierungsrändern der dritten Schicht positive Rampenwinkel erzeugt werden, wodurch sich die freibleibenden Strukturen bei einer Höhe h der dritten Schicht um einen Wert D=2*h/tanα verkleinern und wobei beim Anderen der Strukturierungsprozesse nach der Erzeugung einer Struktur aus einer fotoempfindlichen Schicht für die Bereitstellung einer Maskenschicht für ein Strukturierungsprozess an der dritten Schicht, an den Strukturierungsrändern der dritten Schicht negative Rampenwinkel erzeugt werden, wobei sich die verbleibenden Strukturen bei einer Dicke h der dritten Schicht um einen Wert W=2*h/tanβ verkleinern, und wobei auf der Basis der jeweils strukturierten dritten Schicht eine Strukturierung der zweiten Schicht erfolgt.

Nach dem ersten Strukturierungsprozess wird die dritte Schicht nach deren Strukturierung und Nutzung als Maske zur Strukturierung der zweiten Schicht vollständig entfernt und eine neue dritte Schicht aufgebracht, die im weiteren zweiten Strukturierungsprozess neu strukturiert wird. Dabei ist es völlig unerheblich, ob zunächst die Strukturen mit dem positiven oder negativen Rampenwinkel erzeugt werden.

Durch diese Vorgehensweise ist es möglich, dass auf einem Substrat sich durch die Vergrößerungen und Verkleinerungen der Strukturen an der dritten Schicht Spaltbreiten bzw. Linienbreiten der Strukturen in der zweiten Schicht erzeugen lassen, die unter den minimalen kritischen Dimensionen liegen, die für einen Maskenschritt üblicherweise erreichbar sind.

Im Weiteren ist es bevorzugt, dass nach dem ersten der Strukturierungsprozesse vor dem zweiten Strukturierungsprozess die fotoempfindliche Schicht zur Bereitstellung der Maske entfernt wird. Gegebenenfalls wird nicht nur die fotoempfindliche Schicht zur Bereitstellung der Maske für dritte Schicht, sondern auch die dritte Schicht vollständig entfernt und beide Schichten, d. h. die dritte Schicht als auch die fotoempfindliche Strukturierungsschicht neu aufgetragen.

In einer überdies bevorzugten Ausgestaltung der Erfindung ist es bevorzugt, dass nach der Strukturierung der dritten Schicht eine Strukturierung der zweiten Schicht über die dritte Schicht als Maske vorgenommen wird, um so eine Maske für die erste Schicht zu generieren. Dabei ist es denkbar, diesen Strukturierungsprozess jeweils nach der Strukturierung der dritten Schicht vorzunehmen oder aber die dritte Schicht zu belassen bis sowohl die Minimalspalte, als auch Minimallinien erzeugt sind und dann eine Strukturierung der zweiten Schicht in einem Schritt vorzunehmen.

Als dritte Schicht kann z. B. eine Polymerschicht aufgebracht werden. Vorzugsweise wird eine Schicht eingesetzt, die die Eigenschaften einer Antireflektionsbeschichtung aufweist, z. B. eine BARC-Schicht (bottom antireflex coating).

Auf der Grundlage dieses Verfahrens werden vorzugsweise Substrate mit Halbleiterbauelementen mit Strukturen erzeugt, die Strukturbreiten für Linien und Spalten aufweisen, die im Wesentlichen der Strukturbreiten der verwendeten fotolithographischen Masken zur Herstellung der Strukturen entsprechen, jedoch auf dem gleichen Substrat auch Strukturbreiten realisiert sind, die deutlich unter den minimalen Strukturbreiten der verwendeten fotolithographischen Masken für Linien und Spalten der verwendeten Masken liegen.

Insbesondere werden Substrate mit Halbleiterbauelementen realisiert, bei denen Transistorstrukturen mit Kanallängen unterhalb der minimalen Strukturbreiten der verwendeten fotolithographischen Masken liegen und in der gleichen Ebene im Substrat Gatestrukturen für Transistoren vorhanden sind, deren Abstände unterhalb von minimalen Abständen liegen, die von den verwendeten fotolithographischen Masken zur Erzeugung der Strukturen bereitgestellt werden.

### Zeichnungen

Es zeigen:

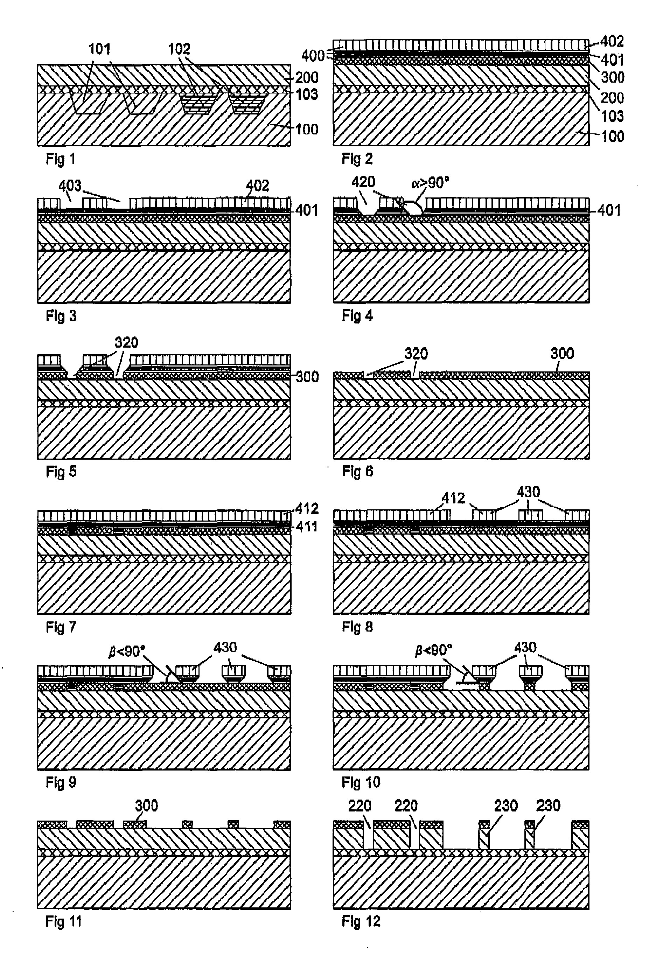

- Figuren 1 bis 12: an schematischen Schnittbildern den Ablauf eines erfindungsgemäßen Verfahrens zur Herstellung von Halbleiterbauelementen auf einem Substrat mit Strukturbreiten, die unter den kritischen Dimensionen liegen.

### Beschreibung des Ausführungsbeispiels:

Ausgangspunkt ist z. B. ein Wafer 100 aus Silizium mit dotierten Bereichen 101, geätzten Strukturen 102, die z. B. als aktive Bereiche eines Transistors genutzt werden, bei welchem die Lücken zwischen den geätzten Strukturen mit Isolationsmaterial aufgefüllt sind, in Prozessen wie z. B. STI (shallow trench isolation) oder LOCOS (Local oxidation of silicon). Auf den Wafer 100 kann ein Dielektrikum 103 aufgebracht sein, das als Dielektrikum für Transistorstrukturen dient. Schließlich folgt auf diese Isolationsschicht eine Schicht aus z. B. Polysilizium, das später zur Herstellung des Gates der Transistoren genutzt wird, beispielsweise in einer Dicke von 200 nm. Die Polysiliziumschicht trägt das Bezugszeichen 200 (siehe Figur 1).

Auf die Schicht 200 wird im Weiteren eine Isolationsschicht, insbesondere eine Siliziumoxidschicht 300 aufgetragen. Diese Schicht sollte chemische Eigenschaften aufweisen, die unterschiedlich zu dem von der darunterliegenden Schicht 200 sind und weist z. B. eine Dicke von 50 nm auf. Damit kann diese Schicht nach ihrer Strukturierung als Maske für die Strukturierung der darunterliegenden Schicht eingesetzt werden.

Darauf wird ein Schichtstapel 400 aufgetragen, der aus verschiedenen Schichten bestehen kann, z. B. eine Antireflektionsbeschichtung 401 sowie eine Photolackschicht 402 aufweist(siehe Figur 2).

Die Photolackschicht wird strukturiert, um eine erste Maske für die darunterliegende Schicht 401 zu erhalten. Dabei werden nur die Strukturen in der Photolackschicht realisiert, mit welchen kleinere Spaltbreiten als die kritische Dimension kreiert werden sollen. Selbstverständlich kann dieser Maskenschritt auch genutzt werden, um Strukturen zu erzeugen, die größer als die minimale Struktur sind. Darüber hinaus können in diesem Maskenschritt Strukturen entstehen, die eine Größe der minimalen Linien im Hinblick auf deren kritische Dimension besitzen. Grundsätzlich wird beim fotolithographischen Prozess das Kriterium der minimalen Strukturbreite eingehalten. Die kleineren Strukturbreiten als die minimale Strukturbreite ergeben sich durch einen nachfolgenden Strukturierungsschritt auf der Grundlage eines fotolithographischen Prozesses im Bereich der minimal möglichen Strukturbreiten.

Letztlich verbleibt eine strukturierte Photolackschicht 402 mit Öffnungen 403 (siehe Figur 3). Mit dieser strukturierten Photolackschicht wird nunmehr die Schicht 401 strukturiert. Ein bevorzugter Ätzschritt findet vorteilhafterweise so statt, dass in der Schicht 401 an den Rändern der Strukturen ein positiver Rampenwinkel entsteht. Damit werden in der Schicht 401 Öffnungen 420 erzeugt, die im Wesentlichen einem konstanten Offset von D=2*h/tanα besitzen, wobei h die Dicke der Schicht 401 ist. Der Winkel α ist per Definition der Winkel, welcher von der schrägen Berandung der Schicht 401 und der Ebene des Wafers eingeschlossen wird. Das bedeutet, dass ein Winkel α von > 90° einem positiven Rampenwinkel entspricht, bei dem Öffnungen 420 mit reduzierter Größe entstehen, wogegen bei einem Winkel α < 90° ein negativer Rampenwinkel vorliegt, bei welchem Öffnungen in der Dimension sich vergrößern. In Figur 4 werden jedenfalls im vorliegenden Schritt Öffnungen 420 verkleinert. Der Rampenwinkel ist positiv (siehe Figur 4).

Mit der strukturierten Schicht 401 wird die darunterliegende Schicht 300 (Maskenschicht) strukturiert. Dadurch erhält man Strukturen 320 (Öffnungen) in der Schicht 300, die den Öffnungen 420 in der Schicht 401 an deren Schichtgrund entsprechen (siehe Figur 5 sowie Figur 6). In Figur 6 ist die Schicht 402 bzw. 401 vor dem nächsten Prozessschritt vollständig entfernt.

Gemäß Figur 7 wird eine Schicht 411 bzw. 412 aufgetragen, wobei die Schicht 411 der Schicht 401 und die Schicht 412 der Schicht 402 entspricht. Die Schicht 412 ist eine Photolackschicht, die entsprechend der Strukturen strukturiert wird, bei welchen eine kleinere Linienbreite erreicht werden soll, als eine Linienbreite, die nach der kritischen Dimension noch möglich ist (siehe Figur 8). In Figur 8 sind Linien 430 ersichtlich. Diese Linien 430 sind unter Nutzung der fotolithographischen Möglichkeiten größer oder gleich der minimalen Linienbreite.

Mit der strukturierten Schicht 412 mit Linien 430 wird die darunterliegende Schicht 411 strukturiert in einer Weise, dass negative Rampenwinkel entstehen. Dadurch verkleinern sich die verbleibenden Linien 430 um jeweils den Rampenwinkelbereich, d. h. die Linien werden um den Wert W=2*h/tanβ kleiner, wobei β der Winkel zwischen der Substratoberfläche und dem nach innen geneigten Rand ist (siehe Figur 9 und Figur 10).

Mit den strukturierten Linien 430 in der Schicht 411 wird die darunterliegende Schicht 300 erneut strukturiert, wobei die Breite der Linien am unteren Rand am Übergang zur Schicht 300 auf die darunterliegende Schicht 300 übertragen wird. Es entstehen subnominale Linienstrukturen, die kleiner sind als die fotolithographische Linienbreite.

Daraufhin werden die Schichten 412 und 411 vollständig entfernt und mit der strukturierten Schicht 300 ein erneuter Strukturierungsvorgang durchgeführt.

Die Schicht 300 enthält nun subnominale Spaltbreiten und subnominale Linienbreiten im Vergleich zu einer kritischen Dimension an den vorgegebenen Stellen. Natürlich kann die Schicht 300 größere Strukturen sowie Strukturen enthalten, die der kritischen Dimension entsprechen.

Mit der strukturierten Schicht 300 wird die darunterliegende Schicht 200, mit welchen die Gates der Transistoren hergestellt werden, strukturiert.

Anschließend ist es möglich, die Schicht 300 zu entfernen und es verbleibt eine strukturierte Polysiliziumschicht 200 mit subnominalen Spalten 220 und subnominalen Linien 230.

Anschließend kann ein herkömmlicher CMOS-Prozess durchgeführt werden.

Um die minimalen Strukturen zu nutzen, sollte im Folgenden eine Implantation zur Erzeugung von Source/Drain-Bereichen in den Bereichen subnominaler Spaltbreiten vermieden werden.

### Bezugszeichenliste:

- 100: Wafer
- 101: dotierte Bereiche
- 102: Strukturen
- 103: Dielektrikum
- 200: Polysilizium
- 220: subnominale Spalte
- 230: subnominale Linie
- 300: Maskenschicht
- 320: Strukturen
- 400: Schichtstapel
- 401: BARC-Schicht
- 402: Photolack
- 403: Öffnung
- 411: BARC-Schicht
- 412: Photolack
- 420: Öffnung
- 430: Linie

## Patentansprüche

1. Verfahren zur Herstellung von Halbleiterbauelementen auf einem Substrat (100) mit fotolithographischen Strukturierungsschritten, bei welchem auf dem Substrat (100) eine erste zu strukturierende Schicht (200) und eine für die erste zu strukturierende Schicht als Maskenschicht dienende zweite Schicht (300) aufgebracht wird, **dadurch gekennzeichnet, dass** eine als Maske für die zweite Schicht dienende dritte Schicht (401) aufgebracht wird und dass nacheinander zumindest zwei fotolithografische Strukturierungsprozesse für die zweite Schicht durchgeführt werden, wobei nach dem ersten Strukturierungsprozess die dritte Schicht nach deren Strukturierung und Nutzung als Maske zur Strukturierung der zweiten Schicht vollständig entfernt und eine neue dritte Schicht aufgebracht wird, die im weiteren zweiten Strukturierungsprozess neu strukturiert wird, wobei bei einem der Strukturierungsprozesse nach der Erzeugung einer Struktur aus einer fotoempfindlichen Schicht (402) zur Bereitstellung einer Maskenschicht für einen Strukturierungsprozess an der dritten Schicht (401), an den Strukturierungsrändern der dritten Schicht positive Rampenwinkel α erzeugt werden, wodurch sich die freibleibenden Strukturen (420) bei einer Dicke h der dritten Schicht um einen Wert D=2*h/tanα verkleinern und wobei beim Anderen der Strukturierungsprozesse nach der Erzeugung einer Struktur aus einer fotoempfindlichen Schicht (412) für die Bereitstellung einer Maskeschicht für einen Strukturierungsprozess an der dritten Schicht (411), an den Strukturierungsrändern der dritten Schicht negative Rampenwinkel β erzeugt werden, wobei sich die verbleibenden Strukturen (430) bei einer Dicke h der dritten Schicht um einen Wert W=2*h/tanβ verkleinern und wobei auf der Basis der jeweils strukturierten dritten Schicht (401) eine Strukturierung der zweiten Schicht (300) erfolgt.

2. Verfahren nach Anspruch 1, **dadurch gekennzeichnet, dass** nach dem ersten der Strukturierungsprozesse vor dem zweiten Strukturierungsprozess die fotoempfindliche Schicht (402) zur Bereitstellung der Maske entfernt wird.

3. Verfahren nach einem der vorhergehenden Ansprüche, **dadurch gekennzeichnet, dass** nach der Strukturierung der dritten Schicht (401) eine Strukturierung der zweiten Schicht (300) über die dritte Schicht (401) als Maske vorgenommen wird, um so eine Maske für die erste Schicht (200) zu generieren.

4. Verfahren nach einem der vorhergehenden Ansprüche, **dadurch gekennzeichnet, dass** die Strukturierung der zweiten Schicht (300) jeweils unmittelbar nach der Strukturierung der dritten Schicht (401, 411) vorgenommen wird.

5. Verfahren nach einem der vorhergehenden Ansprüche, durch gekennzeichnet, dass als erste Schicht (200) eine Polysiliziumschicht aufgebracht wird.

6. Verfahren nach einem der vorhergehenden Ansprüche, durch gekennzeichnet, dass als zweite Schicht (300) eine Siliziumoxidschicht aufgebracht wird.

7. Verfahren nach einem der vorhergehenden Ansprüche, **dadurch gekennzeichnet, dass** eine erste Schicht (200) mit der zweiten Schicht (300) strukturiert wird.

8. Verfahren nach einem der vorhergehenden Ansprüche, durch gekennzeichnet, dass als dritte Schicht (401, 411) eine Polymerschicht aufgebracht wird.

9. Substrat mit Halbleiterbauelementen mit Strukturen (220, 230), die Strukturbreiten für Linien (230) und Spalten (220) aufweisen, die im Wesentlichen der Strukturbreiten der verwendeten fotolithographischen Masken zur Herstellung der Strukturen entsprechen, **dadurch gekennzeichnet, dass** auf dem gleichen Substrat Strukturbereiten realisiert sind, die deutlich unter den minimalen Strukturbreiten der verwendeten fotolithographischen Masken für Linien und Spalten der verwendeten Masken liegen.

10. Substrat mit Halbleiterbauelementen nach Anspruch 9, **dadurch gekennzeichnet, dass** Transistorstrukturen mit Kanallängen unterhalb der minimalen Strukturbreiten der verwendeten fotolithographischen Masken vorgesehen sind, und dass in der gleichen Ebene im Substrat Gate-Strukturen für Transistoren vorhanden sind, deren Abstände unterhalb von minimalen Abständen liegen, die von den verwendeten fotolithographischen Masken zur Erzeugung der Strukturen bereitgestellt werden.
